(19)

Europäisches
Patentamt
European
Patent Office
Office européen
des brevets

(11) **EP 3 605 119 A1**

(12) **EUROPEAN PATENT APPLICATION**

(43) Date of publication:
**05.02.2020 Bulletin 2020/06**

(51) Int Cl.:
***G01R 31/34*** (2020.01)   ***G05B 23/02*** (2006.01)

(21) Application number: **18186572.6**

(22) Date of filing: **31.07.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Aktiengesellschaft
80333 München (DE)**

(72) Inventors:
• **NAIR, Sudev
  560078 Bangalore (IN)**

• **KHALIL, Mohammed
  80807 München (DE)**
• **HEINRICH, Christoph
  86609 Donauwörth (DE)**
• **BOSCO, Arianna
  80638 München (DE)**

(74) Representative: **Isarpatent
Patent- und Rechtsanwälte Behnisch Barth
Charles
Hassa Peckmann & Partner mbB
Friedrichstrasse 31
80801 München (DE)**

(54) **SYSTEM, APPARATUS AND METHOD TO DETECT FAULT IN AN ASSET**

(57)    The present invention provides a system, apparatus and method to detect fault in an asset. The method includes detecting, using at least one processing unit (204), at least one fault indication associated with operation parameters of the asset. The at least one fault indication is detected based on condition data associated with operation of the asset. The method includes generating a fault model representing the operation parameters using fault signatures of the at least one fault indication and detecting the at least one fault in the asset based on the fault model.

FIG 2

**Description**

The present invention relates to detecting fault in an asset.

An asset during operation experiences failure due to several faults. In electro-mechanical systems/devices the faults include mis-alignment, bent shaft, bearing defects, etc.

The faults are identified based on fault indications. The fault indications derived from condition data associated with operation of the asset. Analysis of the fault indications to identify the faults is important from the perspective of service and maintenance.

One of known techniques to identify the faults involves iteratively analyzing a pattern of multiple fault signatures in a motor current signal under harsh, noisy conditions. The patterns of multiple fault signatures are evaluated to effectively reject signal distortions, harsh noise, and interference from the dynamic operation of the electric machine.

The accuracy of the above technique may be largely based on the condition data generated by sensors. Therefore, the technique may depend heavily on how sensors are placed and accuracy of the condition data. Such a technique may not accurately identify the fault, which may lead to failure of the assets and increase in downtime.

In light of the above, there exists a need for accurately detecting faults in assets.

Therefore, it is an object of the present invention to provide a system, apparatus and method for determining faults in one or more assets.

The object of the present invention is achieved by a method to detect at least one fault in an asset based on a fault model. Example of assets include any machinery in a technical system or technical installation/facility such as motor, gear, bearing, shaft, switchgear, rotor, circuit breaker, protection devices, remote terminal units, transformers, reactors, disconnectors, gear-drive, gradient coils, magnet, radio frequency coils etc. Example technical systems include turbines, large drives, Magnetic Resonance Imaging (MRI) scanner, etc. Example facility/technical installation may be a complex industrial set-up with a plurality of assets such as a power plant, wind farm, power grid, manufacturing facility, process plants and so on.

The method comprises receiving various types of data associated with condition of the asset. The condition data is received from different sources (e.g., sensing units, user devices, etc.). The sensing units measure operating parameters associated with the asset. For example, the sensing units may include thermal imaging devices, vibration sensors, current and voltage sensors, etc. The term "operation parameter" refers to one or more characteristics of the asset. Accordingly, the condition data is a measure of the operating parameters associated with the operation of the asset. For example, the condition data includes values of vibration, temperation, current, magnetic flux, velocity, power of a rotor in a turbine.

The method further comprises detecting one or more fault indications associated with operation parameters of the asset using the condition data. The method further comprises generating a fault model representing the operation parameters using fault signatures of the fault indications. The fault signature refers to an electronic footprint of the fault indications in the asset. The fault signatures contain information regarding various health status conditions of the asset. Fault signatures include the validated location each of the fault indications, the location nexus, harmonics, anomaly rate or an anomaly pattern associated with the anomalies in the condition data. For example, fault signature includes a predicted anomaly pattern for different operating profiles such as speed variation and load torque variation. In an embodiment, the method may comprise generating the fault signatures based on the virtual condition data and the condition data of the asset.

The method further comprises detecting one or more fault in the asset based on the fault model. The fault model includes the fault signatures, the operating parameters, interaction between the fault indications and predicted impact of the at fault indications on the asset. The fault model can be scaled to include multiple types of assets and a fleet of same type of assets.

Advantageously, the method uses fault signatures and the virtual replica of the asset to detect, localize and predict faults in the asset.

The method may comprise determining an asset remaining life of the asset based on the faults detected in the asset. Asset remaining life refers to life of the asset with and without the detected faults. The remaining life includes remaining useful life (RUL), down-time, maintenance time, etc. The method may comprise determining a fleet life of a plurality of assets based on the asset remaining life and a fleet variability factor. The fleet variability factor comprises variation in the plurality of assets including variation in operation environment associated with each of the plurality of assests, operation profile of each of the plurality of assests and load profile of each of the plurality of assests. For example, the variation includes difference due to belt driven and direct coupled parameters in belt driven motors and direct coupled motors, respectively.

The method may comprise determining a remaining life of the technical system comprising the asset. The remaining life of the technical system is based on the asset remaining life, availability of spare parts and serviceability parameters. The serviceability parameters include parameters associated serviceability of the asset and the technical system. For example, time required for serviceability, availability of service personel, type of service, frequency of service, etc. The method may further comprise predicting a down-time for the facility based on the asset remaining life and the remaining life of the technical system.

The method may comprise determining anomalies in the condition data based on predetermined threshold values. The predetermined threshold values include operator input values and/or boundary limits of operation of the asset. In an embodiment, the predetermined threshold values are learnt through machine learning algorithms based on anomalies detected in the past. Further, the method may comprise determining whether the anomalies are associated with the fault indications. In other words, the anomalies may be associated with parameters which are responsible for the fault indications. Exemplary parameters may include high temperature, increased vibration, etc. When the anaomalies are associated with the fault indications, locations of the fault indications in the asset are determined. Also, location nexus between each of the locations and the fault indications are determined.

The method may comprise validating the fault indications based on a virtual condition data of the asset. The virtual condition data comprises measure of virtual response from a virtual replica of the asset. The virtual replica includes FEM (finite element models) and network graphs that include machine learning algorithms to predict and replicate operation of the asset. The virtual replica can be a meta model of the asset, which is a simplification of a high-fidelity simulation of the asset. The meta model preserves essential behaviour and dominant effects for the purpose of reducing solution time or storage capacity required for the complex virtual replica. The virtual response is a simulated response from the virtual replica for the operating parameters measured in real-time.

The method advantageously employs meta models of the assets to validate the fault signatures. The meta model can be tuned in real-time to simulate the state of the asset. Therefore, the method can be deployed on a device provided on the asset.

The method may comprise identifying one or more sensing units associated with the fault indications based on type of each of the fault indications. Output of the sensing units i.e. associated values of the operating parameters (also referred as condition data) are provided to a network that illustrates sensitivity of the operating paramters with respect to the fault indications. In an embodiment, the network may be automatically generated based on unsupervised learning techniques that identify localized similarities in the condition data and generates a matrix of the condition data and fault indications. The method may further comprise validating the location of each of the fault indications by comparing condition data associated with the respective sensing units and the related virtual response. In other words, the virtual replica is simulated to confirm the location of fault indications. The validated location is then analysed to determine if any correlation between the validated location and the fault indications.

The method may comprise rendering a representative view of one of the asset and a portion of the asset on a display device (such as desktop monitor, mobile screen, etc). The representative view displays the fault model comprising the fault signatures, the operating parameters, interaction between one or more fault indications and predicted impact of the fault indications on the asset. In an embodiment, the representative view of the portion of the asset, technical system or the facility is rendered on one or more wearable devices. According to an embodiment of the invention, the representative view may be, for example a holographic view. A hologram is a photographic recording of a light field that is used to display a multi-dimensional image of the holographed subject (asset, technical system or facility). The holographic view of the portion of the asset is coupled with information from the fault model pertaining to the detected fault.

The method may comprise rendering a degradation view of one of the asset and the portion of the asset on the display device based on the fault model. The degradation view is based on the fault model and depicts a real-time degradation and a predicted degradation of the asset or the asset portion. The degradation view can be rendered in the same manner as that of the representation view.

The object of the present invention is achieved by an apparatus for detecting faults in an asset located in a facility. The apparatus comprises one or more processing units and a memory unit communicative coupled to the one or more processing units. The memory unit comprises a fault detection module stored in the form of machine-readable instructions executable by the one or more processing units, wherein the fault detection module is configured to perform method steps described above. The execution of the fault detection module can also be performed using co-processors such as Graphical Processing Unit (GPU), Field Programmable Gate Array (FPGA) or Neural Processing/Compute Engines.

According to an embodiment of the present invention, the apparatus can be an edge computing device. As used herein "edge computing" refers to computing environment that is capable of being performed on an edge device (e.g., connected to the sensors unit in an industrial setup and one end and to a remote server(s) such as for computing server(s) or cloud computing server(s) on other end), which may be a compact computing device that has a small form factor and resource constraints in terms of computing power. A network of the edge computing devices can also be used to implement the apparatus. Such a network of edge computing devices is referred to as a fog network.

In another embodiment, the apparatus is a cloud computing system having a cloud computing based platform configured to provide a cloudservice for analyzing condition data of the assets. As used herein, "cloud computing" refers to a processing environment comprising configurable computing physical and logical resources, for example, networks, servers, storage, applications, services, etc., and data distributed over the network, for example, the internet. The cloud computing system provides on-demand network access to a shared pool of the configurable computing physical and logical resources. The network is, for example, a wired network, a wireless network, a communication network, or a network formed from any combination of these networks.

Additionally, the object of the present invention is achieved by a system comprising one or more devices, such as the sensing units, capable of providing condition data associated with operation of assets in a plurality of facilities. The system further comprises an apparatus communicatively coupled to one or more devices as described above. The apparatus is configured to detect the fault in the assets and determine a downtime in at least one of the plurality of facilities.

The object of the present invention is achieved by a computer-program product having machine-readable instructions stored therein, which when executed by a processor, cause the processor to perform a method as describe above.

The above-mentioned and other features of the invention will now be addressed with reference to the accompanying drawings of the present invention. The illustrated embodiments are intended to illustrate, but not limit the invention.

The present invention is further described hereinafter with reference to illustrated embodiments shown in the accompanying drawings, in which:

FIG 1A    is a flowchart illustrating a method of managing a facility including one or more assets, according an embodiment of the present invention;

FIG 1B    is a flowchart illustrating a method of determining remaining life of a technical system including an asset, according an embodiment of the present invention;

FIG 1C    is a flowchart illustrating a method of detecting fault in one or more assets, according an embodiment of the present invention;

FIG 2    illustrates a block diagram of an apparatus to detect one or more faults in an asset, according an embodiment of the present invention;

FIG 3    illustrates a block diagram of a system to detect one or more faults in multiple assets, according an embodiment of the present invention;

FIG 4    illustrates a block diagram of a device to detect one or more faults in a motor, according an embodiment of the present invention;

FIG 5    illustrates an embodiment of a graphical user interface providing a pictorial representation of fault interaction matrix for the motor in FIG 4;

FIG 6    illustrates an embodiment of a graphical user interface providing a pictorial representation of nexus between the fault indications and the motor in FIG 4;

FIG 7    illustrates graphs representing sensitivity of vibration operating parameter on fault indications in the motor in FIG 4; and

FIG 8    illustrates a block diagram of a system to detect one or more faults in multiple fleets of motors, according to an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

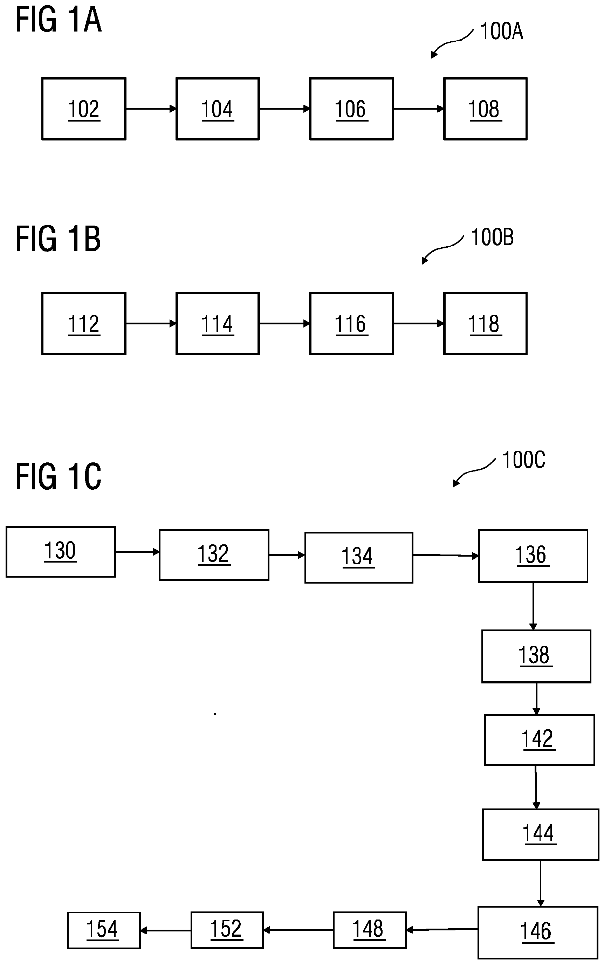

FIG 1A illustrates a flowchart of an embodiment of managing a facility including one or more assets. The asset is located in a facility such as a technical installation. Such facility may be remotely located, for example, in an offshore location. The facility may be a complex industrial set-up with a plurality of assets. Each asset may function individually and/or in collaboration with other assets so as to ensure efficient functioning of the facility. Therefore, breakdown of the asset may lead to failure of the technical system or shut-down of the facility. Thus, fault detection in the assets is of utmost importance.

In managing the facility, the method 100A includes step 102 of detecting fault in one or more assets of the plurality of assets in the facility. At step 104, an asset remaining life is determined for each of the assets based on the fault detected. At step 106, determining impact of the fault on the other assets and availability of replacements. At step 108, a down-time of the facility is determined based on, but not limited to, the impact of the fault, the asset remaining life, service support and the availability of replacements. In an embodiment, the asset is part of a technical system in the facility. Therefore, the fault in the asset impacts performance of the technical system. Accordingly, the down-time of the facility is determined based on impact of the fault on the technical system.

A method 100B of determining the impact of the fault on the technical system is illustrated in FIG 1B. FIG 1B is a flowchart illustrating a method of determining remaining life of a technical system including the asset. For example, the technical system is a turbine which includes a rotating electro-machine. The electro-machine is the asset and fault in the electro-machine in turn results in failure of the turbine.

According to the method in FIG 1B, at step 112 fault in one or more assets of the technical system is determined. At step 114, the asset remaining life is determined for each of the assets based on the fault detected. At step 116, determining availability of spare parts to ensure availability of the technical system. The availability of the technical system is represented mathematically by

$$Availability = \frac{Operating\ time}{Operating\ time + Down\ time}$$

$$= \frac{Mean\ time\ between\ failures\ (MTBF)}{MTBF + Mean\ time\ to\ recover\ (MTTR)}$$

At step 118, a remaining life of the technical system is determined based on the asset remaining life, the availability of spare parts and the serviceability parameters.

In the methods described in FIG 1A and 1B, the detection of fault in the assets is paramount to determine the down-time of the facility and the remaining life of the technical system. The method 100C of detecting fault in the one or more assets is illustrated in FIG 1C.

At step 130, anomalies in condition data is determined based on predetermined threshold values. As used herein, the condition data refers to a measure of operating parameters associated with the operation of the asset. For example, the condition data includes values of vibration, temperation, current, magnetic flux, velocity, power of a rotor in a turbine. The predetermined threshold values include operator input values and/or boundary limits of operation of the asset.

At step 132, association between the anomalies and one or more fault indications is determined. In certain scenarios the anomalies may not be associated to the fault indications. For example, in case of a power shut down. In other scenarios, the anomalies may be associated with parameters which are responsible for the fault indications. Exemplary parameters may include high temperature, increased vibration, etc. At step 134, when the anomalies are associated with the fault indications, the location of the fault indications are determined.

At step 136, the location is determined by identifying one or more sensing units associated with the fault indications. Accordingly, step 136 includes identifying one or more sensing units associated with the fault indications. The sensing units are determined using a database that maps type of each of the fault indications to one or more sensing units. In an embodiment, the sensing units associated with the fault indication are determined based on a virtual replica of the asset. The virtual replica includes FEM (finite element models) and network graphs that include machine learning algorithms to predict and replicate operation of the asset. At step 138, the location of the fault indications is validated by comparing the condition data derived from the sensing units and associated virtual condition data from the virtual replica.

At step 142, the fault indications are analyzed based on the validated location of each of the fault indications. In an embodiment, a location nexus between the location and the fault indications is determined. The location nexus is determined based on a log table that pre-maps the location and the fault indications. In an example, if the location of the fault is at an output shaft of a turbine the fault indications may include shaft misalignment, bent shaft.

At step 144, the fault indications are analyzed to generate the fault signatures based on the virtual condition data and the condition data of the asset. As used herein, the fault signatures comprises the validated location each of the fault indications, the location nexus with the fault indications and an anomaly pattern associated with the anomalies in the condition data. In step 144, the fault signatures are validated based on the virtual replica i.e. based on simulation of the asset.

At step 146, a fault model is generated representing the operation parameters using the fault signatures of the fault indications. As used herein, the fault model includes and is not limited to the fault signatures, the operating parameters, interaction between the fault indications and predicted impact of the at fault indications on the asset. At step 148, faults in the asset are detected based on the fault model. In other words, the faults are determined by analyzing the fault signatures and the predicted impact of the fault indication.

At step 152, a representative view of the asset or a portion of the asset is rendered on a display device. The representative view displays the fault model in conjunction with the multi-dimensional view of the asset or the portion of the asset.

At step 154, a degradation view of the asset or the portion of the asset is rendered on the display device. The degradation view is based on the fault model and depicts a real-time degradation and a predicted degradation of the asset or the asset portion. The step 154 includes determination of the predicted degradation and thereby also includes the asset remaining life determination performed in methods 100A and 100B.

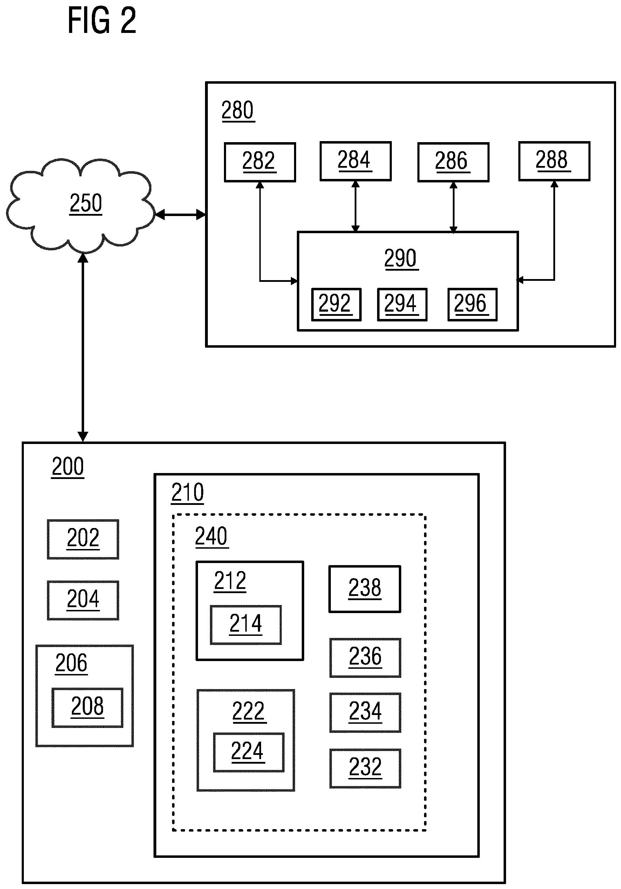

FIG 2 illustrates a block diagram of an apparatus/device 200 to detect one or more faults in an asset 280. The asset includes industrial assets that are located in an industrial plant or an industrial facility. The asset also includes machinery in a technical system. Examples of an asset include motor, rotor, transformer, gear-box, gear-drive, bearing, magnet, coil etc.

The asset 280 is associated multiple sensing units 282, 284, 286, and 288 that measure operation parameters of the asset 280. The term "operation parameter" refers to one or more characteristics of the asset. For example, if an electric motor is the asset, the operation parameters include vibration frequency, vibration amplitude, engine temperature, etc. Further, the asset 280 includes a controller 290 with a trans-receiver 292 capable of connecting to a network interface 250.

In an embodiment, the controller 290 receives condition data from the sensing units 282-288 and transmits the sensor data to the apparatus 200 via the network interface 250. In another embodiment, the controller 290 performs the functions of the apparatus 200. Accordingly, the controller 290 further comprises a processor 294 and a memory 296 comprising modules in the apparatus 200, specifically modules 224, 232, 234, 236 and 238.

The apparatus 200 includes a communication unit 202, at least one processor 204, a display 206, a Graphical User Interface (GUI) 208 and a memory 210 communicatively coupled to each other. The communication unit 202 includes a transmitter, a receiver and Gigabit Ethernet port. The memory 210 may in-elude 2 Giga byte Random Access Memory (RAM) Package on Package (PoP) stacked and Flash Storage. The memory 210 is provided with modules stored in the form of computer readable instructions, for example, 212, 222, 232, 234, 236 and 238. The modules are collectively referred to as fault detection module 240. The processor 204 is configured to execute the defined computer program instructions in the modules. Further, the processor 202 is configured to execute the instructions in the memory 210 simultaneously. The display 206 includes a High-Definition Multimedia Interface (HDMI) display 206 and a cooling fan (not shown in the figure).

According to an embodiment of the present invention, the apparatus 200 is configured on a cloud computing based platform implemented as a service for analyzing data. Additionally, control personnel can access the apparatus 200 via the GUI 208. The GUI 208 is, for example, an online web interface, a web based downloadable application interface, etc.

The memory includes a fault indication module 212, a simulation module 222, a validation module 232, a fault signature module 234, a fault model module 236 and an asset life module 238. The following description explains operation of the modules when executed by the processor 204.

The fault indication module 212 is configured to detect fault indications in the asset. The fault indication module 212 includes an anomaly detection module 214. The anomaly detection module 214 identifies anomalies in the condition data. The condition data refers to signal values of sensors and actuators used to monitor operation of the asset. For example, temperature values, pressure values, etc.

Further, the anomaly detection module 214 is configured to determine whether the anomalies are associated with the at least one fault indication. The anomaly detection module 214 identifies an anomaly pattern and maps the anomaly pattern with the fault indications in the asset based on an association matrix of anomaly pattern and fault indications.

If the fault indications are detected, the fault indication module 212 is configured to determine locations of the fault indications in the asset. In addition, the fault indication module determines a location nexus between the locations and the fault indications.

The simulation module 222 is configured to generate virtual replica of the asset. As used herein the virtual replica is configured to replicate substantially similar operating conditions of the asset. The virtual replica comprises parameter models of the operating parameters, prediction models of the asset based on the condition data and historical condition data of the asset. The virtual replica is updated in real-time to ensure high-fidelity with the asset.

The simulation module 222 includes a meta replica module 224. The meta replica module 224 includes reduced order meta model of the asset, which is a simplification of the high-fidelity virtual replica of the asset. The meta model preserves essential behavior and dominant effects for the purpose of reducing solution time or storage capacity required for the complex virtual replica. To ensure the steps are executed in real-time, select parameters that impact the asset are predicted. For example, a residual stress and a thermal are predicted.

The validation module 232 validates the fault indications based on a virtual condition data of the asset. As used herein, the virtual condition data comprises measure of virtual response from the virtual replica of the asset. The term virtual response indicates vibration, temperature, voltage, current or magnetic flux associated with the operation of the virtual replica in real-time. Validation includes comparison of the condition data and the virtual condition data.

Further, the validation module 232 is configured to identifying one or more sensing units associated with the fault indications based on type of each of the fault indications. Furthermore, the location of each of the fault indications is validated by comparing the condition data measured from the sensing units and the virtual condition data from the associated virtual response of the virtual replica.

The fault signature module 234 in the memory 210 is configured to generate fault signatures of the fault indications based on the validation conducted by the validation module 232. The fault signature refers an electronic footprint of the fault indications in the asset. The fault signature contains information regarding the various health status conditions of the asset. Fault signatures include the validated location each of the fault indications, the location nexus, harmonics, anomaly rate and an anomaly pattern associated with the anomalies in the condition data. For example, fault signature includes predicted anomaly pattern for different operating profiles such as speed variation and load torque variation.

The fault model module 236 generates a fault model representing the operation parameters of the asset using fault signatures of the fault indications. The fault model includes predicted impact of the fault indications and interaction between one or more fault indications. The fault model can be scaled to include multiple types of assets and a fleet of same type of assets. Further, the fault model can be viewed by an expert or an operator of the asset to confirm the validations performed by the validation module 232. The fault model module 236 is configured to determine the fault in the asset based on the fault model.

The asset life module 238 determines an asset remaining life of the asset based on the fault detected. Therefore, the apparatus 200 is capable of predicting the life of the asset at various stages of operation of the asset based on the fault signatures.

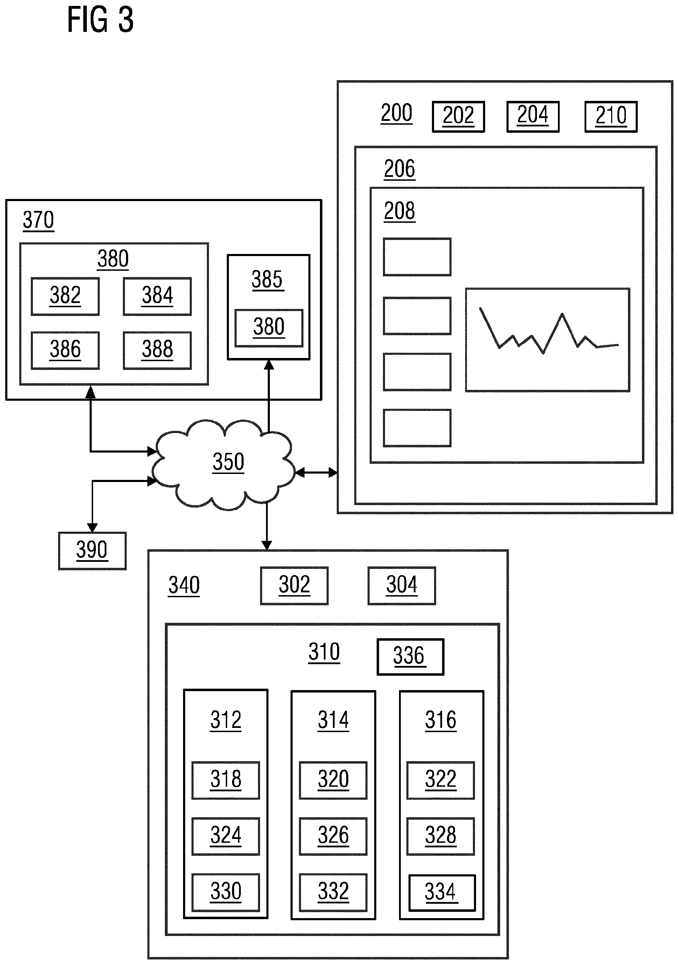

FIG 3 illustrates a block diagram of a system 300 to detect one or more faults in multiple assets 380. The system 300 includes a server 340, a network interface 350 communicatively coupled to the server. In an embodiment, the asset 380 includes sensors 382, 384, 386 and 388 to monitor operation of the asset 380. In another embodiment, the asset 380 is part of a technical system 385. In yet another embodiment, the asset 380 and the technical system 385 are located in a facility 370. The system 300 also includes the apparatus 200 communicatively coupled to the server 340. The operation of the apparatus 200 has been elaborated in FIG 2.

The server 340 includes a communication unit 302, one or more processing units 304 and a memory 310. The memory 310 is configured to store computer program instructions defined by modules, for example, failure identification module 312. In an embodiment, server 340 can also be implemented on a cloud computing environment, where computing resources are delivered as a service over the network 350.

As used herein, "cloud computing environment" refers to a processing environment comprising configurable computing physical and logical resources, for example, networks, servers, storage, applications, services, etc., and data distributed over the network 350, for example, the internet. The cloud computing environment provides on-demand network access to a shared pool of the configurable computing physical and logical resources. The network 350 is, for example, a wired network, a wireless network, a communication network, or a network formed from any combination of these networks.

The processing units 304 in the server execute the following modules: a simulation module 312, a life module 314, an availability module 316, and a maintenance module 336.

The simulation module 312 is configured to generate virtual replica of the assets 380, the technical system 385 and the facility 370. Therefore, the virtual replica is configured to replicate substantially similar operating conditions of the assets 380, the technical system 385 and the facility 370. The simulation module 312 includes asset simulation module 318 configured to simulate each of the assets 380. For example, the instructions in the asset simulation module 318 include instructions of the simulation module 222.

Apart from the simulation of the asset, the simulation module 312 includes a system simulation module 324 of the technical system 385 and a facility simulation module 330 of the facility 370. The system simulation module 324 includes 1-dimensional and/or 3-dimensional simulation of the asset 380 and the interaction between the asset 380 and other components (not shown in FIG. 3) within the technical system 385. Similarly, the facility simulation module 330 includes simulation of the technical system 385 and the assets 380 with their interactions in the facility simulation 370.

The life module 314 includes asset life module 320, fleet life module 326, and system life module 332. On executing the asset life module 320, the asset life is determined in a similar manner as that of the asset life module 238. The fleet life module 326 is configured to determine a fleet life of the assets 380 based on the asset remaining life and a fleet variability factor. The fleet variability factor refers to variation in the assets 380 including variation in operation environment associated with each of the assets 380, operation profile of each of the assets 380 and load profile of each of the assets 380.

The system life module 332 is configured to determine a remaining life of the technical system 385 comprising the asset 380. The system life module 332 determines the remaining life based on the asset remaining life, availability of spare parts and serviceability parameters. The serviceability parameters include parameters associated serviceability of the asset 380 and the technical system 385. For example, time required for serviceability, availability of service personel, type of service, frequency of service, etc.

The availability module 316 includes asset availability module 322, system availability module 328 and facility availability module 334. The asset availability module 322 predicts availability of the asset 380 based on the asset remaining life and the serviceability parameters. The system availability module 328 determines availability of the technical system 385 based on the asset availability and the remaining life of the technical system 385. Further, the facility availability module 334 predicts a down-time for the facility 370 based on the asset remaining life and/or the remaining life of the technical system 385.

The maintenance module 336 is configured to determine a third party maintenance center 390 that is capable of providing service and maintenance to the asset 380, system 385 and facility 370. The maintenance center 390 is determined such that the availability of the asset 380, system 385 and the facility 370 is optimized.

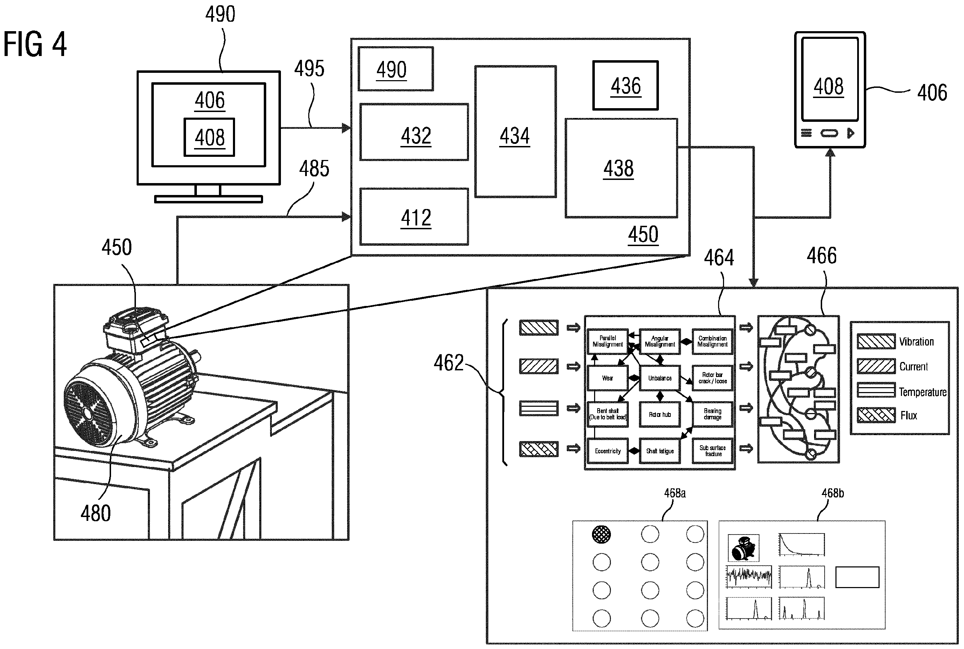

FIG 4 illustrates a block diagram of a device 450 to detect one or more faults in a motor 480 according an embodiment of the present invention. The motor 480 that includes sensors such as a vibration sensor and a thermostat (not shown in FIG. 4). The device 450 includes a processor and a memory (not shown in FIG. 4). The memory including modules 412, 432, 434, 436 and 438. It will be appreciated by a person skilled in the art that the operation of the device 450 is similar to apparatus 200.

Further, FIG 4 illustrates a simulation platform 490 connected a display device 406. In an embodiment, the display device 406 is part of the simulation platform 490. In another embodiment, the display device 406 is a mobile computing device with a screen. The display device 406 is provided with a Graphical User Interface (GUI) 408 to enable analysis of fault indications / faults when detected in the motor 480.

The device 450 is placed on the motor 480 or in close proximity. As shown in the figure, a real-time response 485 is generated by the motor 480. The real-time response 485 includes data from the sensors and is referred to as condition data. The condition data indicates real-time condition of the motor 480.

The device 450 includes a fault indication module 412 by identifying anomalies in the condition data from the motor 480. In addition, the fault indication module 412 identifies an anomaly pattern in the condition data and maps the anomaly pattern with the fault indications in the asset.

The simulation platform 490 includes a virtual replica of the motor 480. A virtual response 495 is generated by means of the virtual replica in the simulation platform 490. In an embodiment, the simulation platform 490 is in the device 450 and includes a meta model of the motor 480. The meta model preserves essential behavior and dominant effects for the purpose of reducing solution time or storage capacity required for the virtual replica.

The device 450 includes a validation module 432 that validates the fault indications based on a virtual condition data generated from the virtual response 495. A fault signature module 434 in the memory is configured to generate fault signatures of the fault indications based on the validation conducted by the validation module 432. Further, a fault model module 436 generates a fault model representing the operation parameters of the motor 480 using fault signatures of the fault indications. Furthermore, a motor life module 438 determines a motor remaining life of the motor 480 based on the fault detected.

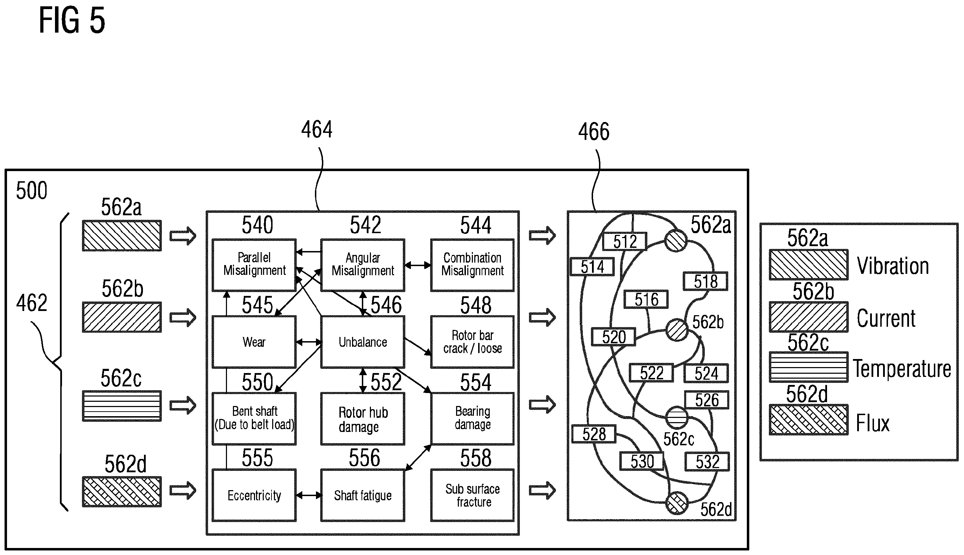

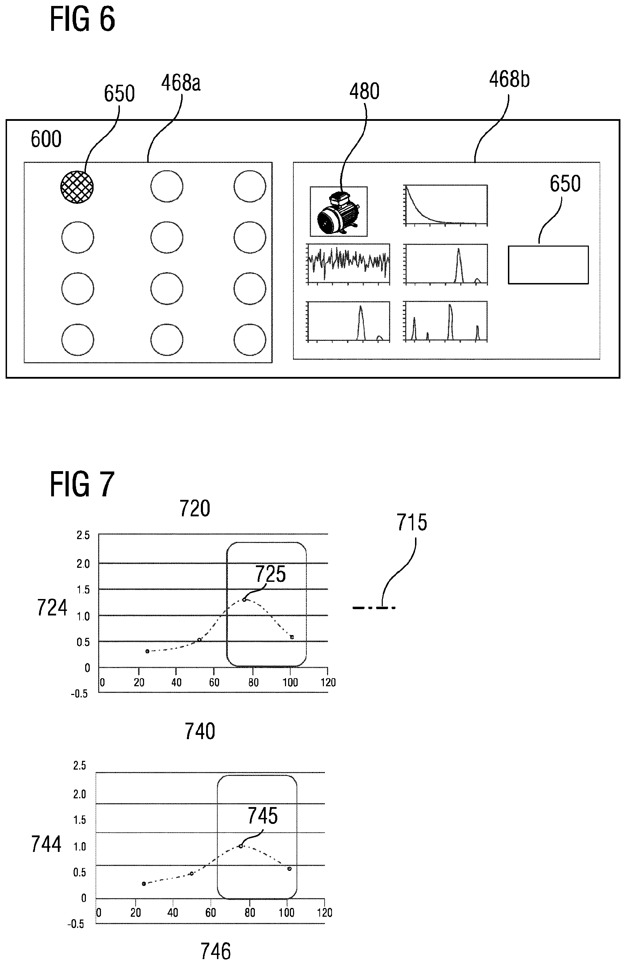

As shown in FIG 4, the GUI 408 displays an fault interaction matrix mapping the operating parameters 462 and the fault indications 464 to indicate fault interactions in a fault network 466. The fault interaction matrix is explained in FIG 5. The GUI 408 also displays a fault analysis snapshot with the detected fault 468a and fault analysis 468b. The fault analysis snapshot is explained in FIG 6. The fault analysis 468b enables an expert or a service personel to understand and mitigate impact of the fault in a timely manner.

FIG 5 illustrates an embodiment of a graphical user interface 500 providing a pictorial representation of the fault interaction matrix for the motor in FIG 4. The operation parameters are cumulatively referred by the numeral 462 as in FIG 4. The operation parameters are refered by numerals 562a-562d for the purpose of FIG 5. For example, the operating parameters 462 include vibration 562a, current 562b, temperature 562c and magnetic flux 562d.

In addition to the operating parameters 562a-562d, FIG 5 illustrates the fault indications 464. The fault indications 464 includes parallel misalignment 540, angular misalignment 542, combination misalignment 544, wear 545, unbalance 546, rotor bar crack/loose 548, bent shaft 550, rotor hub damage 552, bearing damage 554, eccentricity 555, shaft failure 556 and sub surface fracture 558.

The operating parameters 562a-562d indicate different levels of sensors that are used to differentiate and localize fault indications occur in the motor. The correlation between fault indications and the operating parameters 562a-562d is indicated by the fault network 466. The fault network 466 illustrates identification of faults by understanding sensitivity of operating paramters 562a-562d on the fault indications. The fault network 466 is advantageous as it enables location of the fault indications with high accuracy and precision. Therefore, the fault network 466 accurate detection of the fault and fault isolation.

Examples of fault detection and isolation is illustrated in FIG. 5 by detection of faults 512, 514, 516, 518, 520, 522, 524, 526, 528, 530 and 532. The fault 512 is detected based on sensitivity/response of the motor 480 and the virtual replica to operating paramters 562a, 562c and 562d (i.e. vibration, temperature and flux). For example, fault 518 is detected based on the response of the motor 480 to vibration 562a and current 562b. In an embodiment, the fault 518 is classified as misalignment. For faults like misalignment further isloation of parallel and angular misalignment is performed. For example, parallel and angular misalignment are identified by actuating 3X (75Hz) and 4X (100Hz) in vibration 562a and temperature 562c. The changed operating parameters 562a, 562c are provided to the virtual replica of the motor to generate the virtual response. By changing the operating parameters 562a, 562c the location of the fault indications is identified by comparing virtual response and the real-time data from the motor. The present example is illustrated in FIG 7.

FIG 7 illustrates graphs representing sensitivity of vibration operating parameter on angular misalignment 720 and parallel misalignment 740. Time series of the condition data is indicated by the line 715. The y-axis 724 and 744 indicates acceleration in terms of meters per square second. The x-axis 726 and 746 refers to frequency in Hertz. Comparing points 725 and 745, it is seen that at 75Hz, the angular misalignemt is 1.25 as compared to the parallel misalignment 0.65.

FIG 6 illustrates an embodiment of a graphical user interface (GUI) 600 providing a pictorial representation of nexus between the fault indications and the motor. The fault indications 468a and detected fault 650 are illustrated. The analysis of the fault is indicated in 468b through a rendered view of the motor 480 and the condition data that lead to the detected fault. For example, parallel misalignment, correlation between the identified fault and temperature, vibration is represented. Through the GUI, a user is readily aware that even though the vibration may indicate a different fault, higher temperature and increased vibration refers to parallel misalignment.

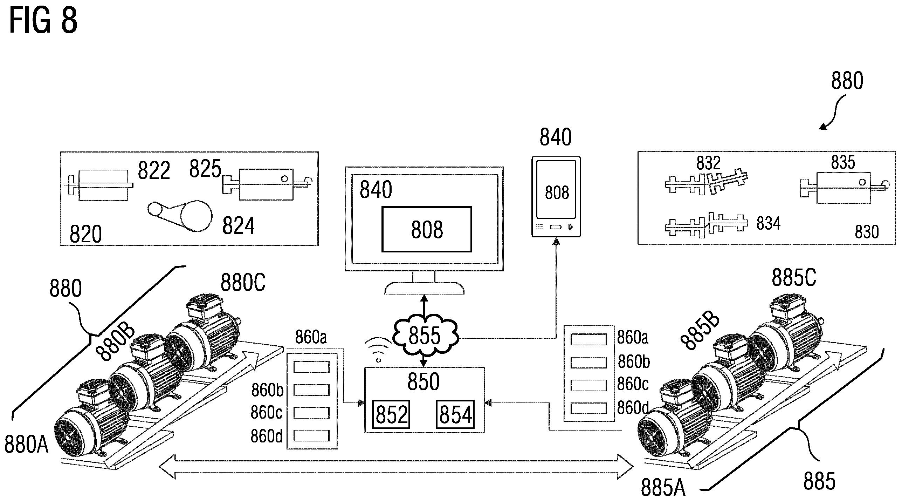

FIG 8 illustrates a block diagram of a system 800 to detect one or more faults 825, 835 in multiple fleets of motors 880, 885. As shown in the figure, each fleet includes multiple motors 880A-880C and 885A-885C. The operating parameters are measured through sensor/sensing units like heat cameras. Condition data of the fleets 880, 885 are a measure of the operating paramters for fleet 880 referred by the numerals 860a-860d and for fleet 885 by numerals 865a-865d.

The condition data 860a-860d and 865a-865d is forwarded to a fog network 850. The fog network 850 refers to a network of edge computing devices capable of processing and analyzing input at the edge devices. An edge device is any resource constrained device with access to a cloud network 855, such as a smart sensor, a gateway, a mobile computing device, etc. The fog network 850 is connected to a remote server 840 provided with a display 808. The remote server 840 is comunicatively coupled to the fog network 850 through the cloud network 855. The display 808 renders illustration of fault conditions/modes 820 and 830 to analyze the faults 825 and 835. The fault modes 820 and 830 include representation of the faults 825, 835 and fault indications 822, 824 and 832, 834, respectively.

FIG 8 illustrates an example of the fleet 880 including belt driven Motors with 7.5kilo Watt, 2880 rate per minute and the fleet 885 including directly coupled motors with 5.5kilo Watt, 1440 rate per minute. The fleets 880 adn 885 are part of low power motor fleet.

The fleet 880 with belt driven motors are likely to be detected with faults 825 like bent shaft due to static and dynamic belt force, belt alignment problems, bearing faults and un balance at rotor side as well as at pulley side. In case of the fleet 885 with directly coupled motors, faults 835 like angular misalignment, parallel misalignment, combination misalignment, unbalances at rotor are likely to be detected.

The fog network 850 includes one or more processing units 852 and memory 854. The memory 854 includes a simulation module configured to generate virtual replicas for each of the motors 880A-880C and 885A-885C. The simulation module includes a Digital Signal Processing (DSP) unit which include simulated as well as experimental models calibrated to predict failures. In the present embodiment, the simulation module is a meta model is embedded into the edge devices for real-time simulation. The meta model is fine tuned based on the condition data and load profiles of the motors 880A-880C and 885A-885C.

The memory 854 also includes a fleet life module configured to determine a fleet life of the fleets 880 and 885 based on remaining life of each of the motors 880A-880C and 885A-885C and a fleet variability factor. The fleet variability factor refers to variation in the motors 880A-880C and 885A-885C. In FIG 8, the variation includes difference due to belt driven and direct coupled parameters. In addition, the fleet variability factor includes variation in operation environment associated with each of the motors 880A-880C and 885A-885C, defect tolerances of each of the the motors 880A-880C and 885A-885C and load profile of each of the the motors 880A-880C and 885A-885C.

The present invention can take a form of a computer program product comprising program modules accessible from computer-usable or computer-readable medium storing program code for use by or in connection with one or more computers, processors, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology can be centralized or distributed (or a combination thereof) as known to those skilled in the art.

FIG 2
Apparatus 200
asset 280
sensing units 282, 284, 286, and 288
controller 290
trans-receiver 292
network interface 250.
processor 294
memory 296
communication unit 202
one processor 204
display 206
Graphical User Interface (GUI) 208
memory 210
fault indication module 212
simulation module 222
validation module 232
fault signature module 234
fault model module 236
asset life module 238
anomaly detection module 214
meta replica module 224
validation module 232
fault signature module 234
fault model module 236
asset life module 238
fault detection module 240

FIG 3
system 300
assets 380
server 340
network interface 350
asset 380
sensors 382, 384, 386 and 388
technical system 385
facility 370
communication unit 302
processing units 304
memory 310
simulation module 312
life module 314
availability module 316
maintenance module 336.
asset simulation module 318
system simulation module 324
facility simulation module 330
asset life module 320
fleet life module 326
system life module 332
asset availability module 322
system availability module 328
facility availability module 334
maintenance center 390

FIG 4
device 450
motor 480
simulation platform 490
display device 406
Graphical User Interface (GUI) 408
real-time response 485
fault indication module 412
virtual response 495
validation module 432
fault signature module 434
fault model module 436
motor life module 438
operating parameters 462
fault indications 464
fault network 466
detected fault 468a
fault analysis 468b

FIG 5
graphical user interface 500
faults 512, 514, 516, 518, 520, 522, 524, 526, 528, 530 and 532
parallel misalignment 540
angular misalignment 542
combination misalignment 544
wear 545
unbalance 546
rotor bar crack/loose 548
bent shaft 550
rotor hub damage 552
bearing damage 554
eccentricity 555
shaft failure 556
sub surface fracture 558
vibration 562a
current 562b
temperature 562c
magnetic flux 562d

FIG 6
graphical user interface (GUI) 600
detected fault 650

FIG 7
angular misalignment 720
parallel misalignment 740
Time series of the condition data 715
y-axis acceleration 724 and 744
x-axis frequency 726 and 746

FIG 8
system 800
faults 825, 835
fleets of motors 880, 885
motors 880A-880C and 885A-885C
operating paramters 860a-860d and 865a-865d.
fog network 850
memory 854

cloud network 855
remote server 840
display 808
fault conditions/modes 820 and 830
faults 825 and 835
fault indications 822, 824 and 832, 834

**Claims**

1. A computer-implemented method for detecting at least one fault in an asset (280, 380, 480, 880, 885), the method comprising:

   detecting, using at least one processing unit (204), at least one fault indication associated with operation parameters of the asset, wherein the at least one fault indication is detected based on condition data associated with the operation of the asset;
   generating a fault model representing the operation parameters using fault signatures of the at least one fault indication; and
   detecting the at least one fault in the asset (280, 380, 480, 880, 885) based on the fault model.

2. The method according to claim 1, further comprising:
   determining an asset remaining life of the asset based on the at least one fault in the asset.

3. The method according to claim 2, further comprising:
   determining a fleet life of a plurality of assets (880, 885) based on the asset remaining life and a fleet variability factor, wherein the fleet variability factor comprises variation in the plurality of assets including variation in operation associated with each of the plurality of assests, operation profile of each of the plurality of assests and load profile of each of the plurality of assests.

4. The method according to claim 1, further comprising:
   determining a remaining life of a technical system (385) comprising the asset based on the asset remaining life, availability of spare parts and serviceability parameters.

5. The method according to claim 1, wherein the asset is located in a facility (370), wherein the method further comprising:
   predicting a down-time for the facility (370) based on at least one of the asset remaining life and the remaining life of the technical system (385).

6. The method according to claim 1, further comprising:

   determining anomalies in the condition data based on predetermined threshold values, wherein the condition data comprises measure of the operating parameters associated with the operation of the asset;
   determining whether the anomalies are associated with the at least one fault indication, wherein the at least one processing unit detects the at least one fault indication in the asset, when the anaomalies are associated with the at least one fault indication; and
   if the anomalies are associated with the at least one fault indication, determining location of the at least one fault indication in the asset; and
   determining a location nexus between the location and the at least one fault indication.

7. The method according to one of claim 1 and claim 6, further comprising:
   validating the at least one fault indication based on a virtual condition data of the asset, wherein the virtual condition data comprises measure of virtual response from a virtual replica of the asset.

8. The method according to claim 7, further comprising:

   identifying one or more sensing units (282-288) associated with one or more fault indications based on type of each of the fault indications;
   validating a location of each of the fault indications by comparing condition data associated with the respective sensing units and the related virtual response; and
analyzing each of the fault indication based on the validated location of each of the fault indications.

9. The method according to one of claims 1 and 8, further comprising:
generating the fault signatures based on the virtual condition data and the condition data of the asset, wherein the fault signatures comprises the location each of the fault indications, the location nexus with the at least one fault indication and an anomaly pattern associated with the anomalies in the condition data.

10. The method according to any of claims 1 to 9, further comprising:
rendering a representative view of one of the asset and a portion of the asset on a display device (206, 406, 808), wherein the representative view displays the fault model comprising the fault signatures, the operating parameters, interaction between one or more fault indications and predicted impact of the at least one fault indication on the asset.

11. The method according to any of claims 1 to 10, wherein detecting the at least one fault in the asset based on the fault model comprises:
determining the at least one fault in the asset is based on the fault signatures and the predicted impact of the at least fault indication.

12. The method according to any of claims 1 to 11, further comprising:
rendering a degradation view of one of the asset and the portion of the asset on the display device (206, 406, 808) based on the fault model.

13. An apparatus (200) for detecting at least one fault in an asset (280, 380), the apparatus comprising:

one or more processing units (204); and
a memory unit (210) communicative coupled to the one or more processing units, wherein the memory unit (210) comprises a fault detection module (240) stored in the form of machine-readable instructions executable by the one or more processing units (204), wherein the fault detection module (240) is configured to perform method steps according to claims 1 to 12.

14. A system (800) comprising:

one or more devices (850) capable of providing condition data associated with operation of assets in a plurality of facilities; and
an apparatus (200) communicatively coupled to the device according to claim 13, wherein the apparatus (200) is configured for detect at least one fault in at least one of the assets (880, 885) and determine a down-time in at least one of the plurality of facilities.

15. A computer-program product having machine-readable instructions stored therein, which when executed by one or more processing units (204), cause the processing units (204) to perform a method according to claims 1 to 12.

## FIG 1A

100A

┌─────┐     ┌─────┐     ┌─────┐     ┌─────┐
│ 102 │ ──→ │ 104 │ ──→ │ 106 │ ──→ │ 108 │
└─────┘     └─────┘     └─────┘     └─────┘

## FIG 1B

100B

┌─────┐     ┌─────┐     ┌─────┐     ┌─────┐
│ 112 │ ──→ │ 114 │ ──→ │ 116 │ ──→ │ 118 │
└─────┘     └─────┘     └─────┘     └─────┘

## FIG 1C

100C

┌─────┐     ┌─────┐     ┌─────┐     ┌─────┐
│ 130 │ ──→ │ 132 │ ──→ │ 134 │ ──→ │ 136 │
└─────┘     └─────┘     └─────┘     └─────┘
                                        │
                                        ↓
                                    ┌─────┐
                                    │ 138 │
                                    └─────┘
                                        │
                                        ↓
                                    ┌─────┐
                                    │ 142 │
                                    └─────┘
                                        │
                                        ↓
                                    ┌─────┐
                                    │ 144 │
                                    └─────┘
                                        │
                                        ↓
┌─────┐     ┌─────┐     ┌─────┐     ┌─────┐
│ 154 │ ←── │ 152 │ ←── │ 148 │ ←── │ 146 │
└─────┘     └─────┘     └─────┘     └─────┘

# FIG 2

# FIG 3

# FIG 4

EP 3 605 119 A1

# FIG 5

462 {
- 562a — Vibration (hatched box)
- 562b — Current (hatched box)
- 562c — Temperature (hatched box)
- 562d — Flux (hatched box)

464

| 540 Parallel Misalignment | 542 Angular Misalignment | 544 Combination Misalignment |
|---|---|---|
| 545 Wear | 546 Unbalance | 548 Rotor bar crack / loose |
| 550 Bent shaft (Due to belt load) | 552 Rotor hub damage | 554 Bearing damage |
| 555 Eccentricity | 556 Shaft fatigue | 558 Sub surface fracture |

466

512, 514, 516, 518, 520, 522, 524, 526, 528, 530, 532
562a, 562b, 562c, 562d

Legend:
- 562a Vibration
- 562b Current
- 562c Temperature
- 562d Flux

500

EP 3 605 119 A1

# FIG 6

600

650  468a  480  468b

650

# FIG 7

720

715

725

724

740

745

744

746

FIG 8

EP 3 605 119 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/055666 A1 (RODDY NICHOLAS E [US] ET AL) 20 March 2003 (2003-03-20) * abstract; figures 1-16 * * paragraphs [0006] - [0008] * ----- | 1-15 | INV. G01R31/34 G05B23/02 |
| X | US 2014/188778 A1 (GARVEY DUSTIN ROSS [US] ET AL) 3 July 2014 (2014-07-03) * abstract; figures 1-5 * * paragraphs [0006] - [0008], [0024] * ----- | 1-15 | |
| X | US 2018/082217 A1 (BATES ALEXANDER B [US] ET AL) 22 March 2018 (2018-03-22) * abstract; figures 3-5,7-10 * * paragraphs [0005] - [0008], [0024] * ----- | 1-15 | |

TECHNICAL FIELDS
SEARCHED     (IPC)

G01R
G05B

The present search report has been drawn up for all claims

| Place of search | Date of completion of the search | Examiner |
|---|---|---|
| Munich | 10 January 2019 | Kleiber, Michael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 18 6572

This annex lists the patent family members relating to the patent documents cited in the above-mentioned European search report.
The members are as contained in the European Patent Office EDP file on
The European Patent Office is in no way liable for these particulars which are merely given for the purpose of information.

10-01-2019

| Patent document cited in search report | Publication date | Patent family member(s) | Publication date |
|---|---|---|---|
| US 2003055666 A1 | 20-03-2003 | NONE | |
| US 2014188778 A1 | 03-07-2014 | NONE | |
| US 2018082217 A1 | 22-03-2018 | US 2016116378 A1<br>US 2018082217 A1 | 28-04-2016<br>22-03-2018 |

EPO FORM P0459

For more details about this annex : see Official Journal of the European Patent Office, No. 12/82